Europäisches Patentamt

European Patent Office

Office européen des brevets

(11) Numéro de publication: **0 068 195**
**A1**

(12) **DEMANDE DE BREVET EUROPEEN**

(21) Numéro de dépôt: **82105010.1**

(22) Date de dépôt: **08.06.82**

(51) Int. Cl.³: **H 05 K 7/14, H 01 R 23/68**

(30) Priorité: **12.06.81 FR 8111569**

(71) Demandeur: **COMPAGNIE INDUSTRIELLE DES TELECOMMUNICATIONS CIT-ALCATEL S.A. dite:, 12, rue de la Baume, F-75008 Paris (FR)**

(43) Date de publication de la demande: **05.01.83 Bulletin 83/1**

(72) Inventeur: **Petit, André, 12, Clos des Maraîchers, F-91310 Longpont sur Orge (FR)**
Inventeur: **Jamet, Daniel, 9, Allée des Iris Hameaux de Villiers, F-91620 Nozay (FR)**

(84) Etats contractants désignés: **BE DE GB IT LU NL**

(74) Mandataire: **Weinmiller, Jürgen et al, Zeppelinstrasse 63, D-8000 München 80 (DE)**

(54) **Châssis d'équipement électronique.**

(57) Le châssis d'équipement électronique, destiné à recevoir des cartes de circuit imprimé portant des composants et à assurer au moins les connexions, entre circuits définis par les cartes individuelles, comporte deux plateaux (1a, 1b) fixés, à une distance l'un de l'autre sensiblement égale à la hauteur desdites cartes (3), sur deux montants (2a, 2b), chacun de ces plateaux étant constitué par un ensemble de glissières (10a, 10b), à rainures de guidage desdites cartes, disposées d'un plateau à l'autre en vis-à-vis, chacune équipée intérieurement d'un connecteur de circuit imprimé à contacts mobiles transversalement à la rainure de la glissière correspondante, à proximité de cette rainure.

## Châssis d'équipement électronique

La présente invention porte sur les châssis d'équipement électronique permettant le montage d'appareillages de télécommunications ou de traitement de l'information en bâti ou en coffrets.

De manière bien connue, de tels châssis sont utilisés pour le montage et l'assemblage de cartes imprimées supportant des composants électroniques et la connexion des circuits définis sur chacune de ces cartes entre eux et avec des circuits extérieurs montés ou non dans des châssis semblables. De tels châssis sont en général de dimensions définies pour chacun des circuits qu'il reçoit.

Les châssis traditionnels forment une sorte de caisson parallélépipédique ouvert sur une face, dite face avant, portant sur sa face arrière une pluralité d'embases constituant des connecteurs femelles disposés en colonnes sur la hauteur de cette face et portant sur chacune de ses faces supérieure et inférieure des rainures, nervures ou autres moyens définissant intérieurement des moyens de guidage de chacune des cartes de circuit imprimé en relation avec les embases disposées dans la face arrière. Chacune des cartes de circuit imprimé introduite dans l'un de ces châssis, par sa face avant, est munie d'un ou plusieurs connecteurs mâles disposés sur l'un de ses côtés, dit côté arrière, venant alors s'insérer dans l'embase correspondante de la face arrière du châssis. Les connexions entre circuits définis par les différentes cartes montées dans ce châssis sont réalisées, extérieurement, sur la face arrière du châssis, tandis que les connexions de ces circuits à d'autres circuits extérieurs à ce châssis seront réalisées par des câblages ou une nappe de fils courant sur la face arrière du châssis ou reportés de cette face arrière sur au moins l'une des faces latérales jusqu'à une barrette de raccordement disposée sur l'une ou l'autre ou chacune de ces faces latérales, en prolongeant la face avant du châssis.

L'ensemble des circuits définis par les cartes de circuit imprimé contenues dans l'un des châssis et raccordés entre eux et prêts à être raccordés à d'éventuels circuits extérieurs définit alors l'équipement électronique de ce châssis, qui constitue tout ou partie de l'appareillage à réaliser.

Les défauts inhérents à ces châssis portent sur l'insertion ou l'extraction des cartes de circuit imprimé, cette insertion ou extraction étant d'autant plus difficile que le nombre de contacts portés par la carte est élevé et exigeant dans tous les cas un guidage précis de chacune des cartes dans le châssis de manière à ce que les connecteurs et les embases soient face à face et viennent assurer les contacts souhaités dans de bonnes conditions de qualité.

On connaît également notamment par le document US-A 4158 220 délivré le 12 juin 1979, un châssis d'assemblage de cartes de circuit imprimé permettant une interconnexion aisée entre cartes. La structure décrite dans ce brevet comporte une base, quatre montants utilisés en tant que supports entre lesquels sont fixés trois plateaux latéraux dits cartes mères définissant sur la base la forme de caisson, mais également comme conducteurs d'alimentation de l'ensemble des circuits reçus dans le châssis. Des connecteurs à force d'insertion nulle sont fixés sur chacun de ces plateaux, de manière correspondante d'un plateau à l'autre, pour recevoir et maintenir les cartes de circuit imprimé mais également assurer leur raccordement avec des réseaux de pistes conductrices imprimées sur chacun des plateaux.

La présente invention a pour but, tout en conservant les avantages quant à l'interconnexion entre les circuits qu'il reçoit, de simplifier la réalisation de tels châssis et en particulier de les rendre aisément adaptables aux dimensions des jeux de cartes de circuits imprimés qu'ils doivent respectivement recevoir et au positionnement relatif des cartes de chacun des jeux.

L'invention sera décrite ci-après plus en détail à l'aide d'un exemple de réalisation illustré dans les dessins ci-annexés. Dans ces dessins :

- la figure 1 est une vue en perspective du châssis selon l'invention pour le montage d'un équipement électronique dans un bâti,

- la figure 2 est une vue en perspective de deux éléments du châssis de la figure 1,

- la figure 3 est une vue en perspective éclatée de l'équipement de l'un des éléments de la figure 2,

- la figure 4 est une vue de dessus d'une glissière équipée de son connecteur, rentrant dans la constitution du châssis de la figure 1,

- la figure 5 est une vue en élévation avec des coupes longitudinales partielles d'une glissière du châssis selon la figure 1,

- la figure 6 est une vue en perspective partielle éclatée de la glissière, selon la figure 4, équipée de son connecteur,

- les figures 7A et 7B sont deux vues en perspective partielle de la partie avant de commande d'une glissière d'un châssis selon la figure 1 équipée de son connecteur mis en position ouverte et en position fermée, respectivement,

- les figures 8A et 8B sont deux vues en coupe de l'une des glissières des figures 4 et 5 équipée de son connecteur, correspondant aux positions ouverte et fermée du connecteur, respectivement,

- la figure 9 est une vue en perspective du châssis selon la figure 1 complété pour le montage d'un équipement électronique en coffret.

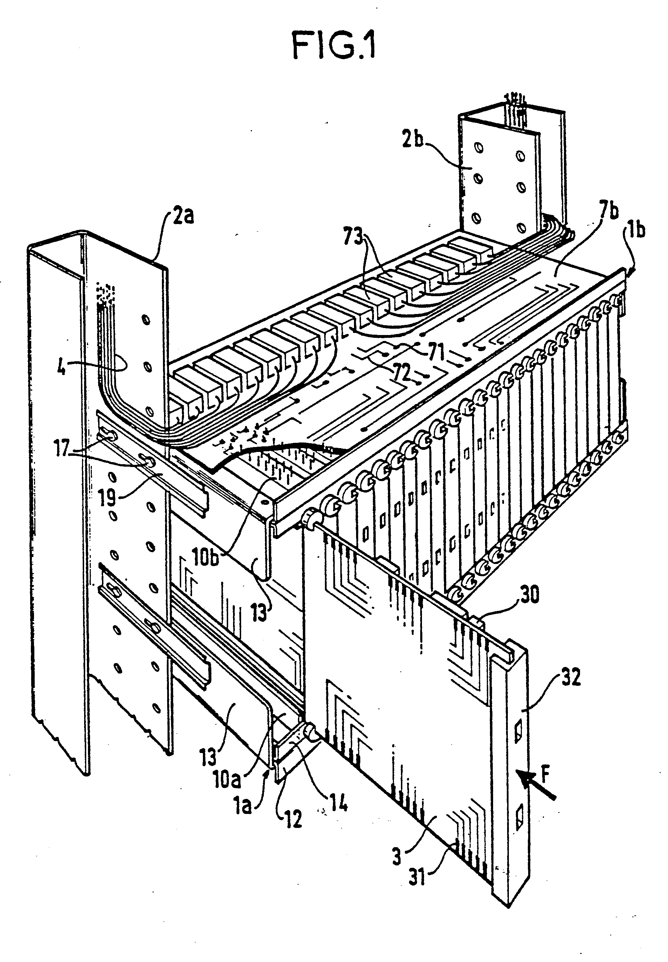

En se référant aux figures 1 à 3, on voit que le châssis conforme à l'invention est constitué par deux plateaux 1a et 1b fixés en regard l'un de l'autre sur deux montants 2a et 2b, en étant écartés l'un de l'autre sensiblement de la hauteur de cartes de circuit imprimé, telles que la carte 3, que le châssis doit recevoir.

Les montants sont ici ceux d'un bâti et se présentent ici sous forme de gouttière, de section en U, pour le logement de câbles 4 de raccordement de l'équipement électronique de ce châssis à ceux d'autres châssis montés dans ce bâti.

Chacun des plateaux 1a et 1b comporte un ensemble de glissières telles que 10a ou 10b, chacune à rainure longitudinale non référencée séparément dans ces figures et chacune équipée intérieurement ainsi qu'il sera vu ci-après d'un connecteur à force d'insertion nulle.

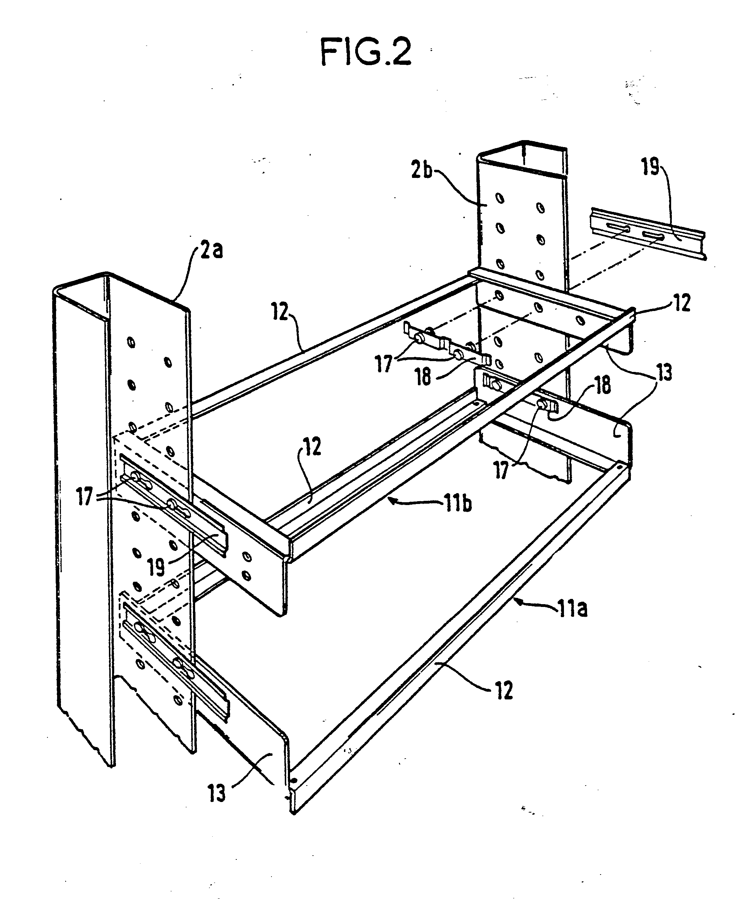

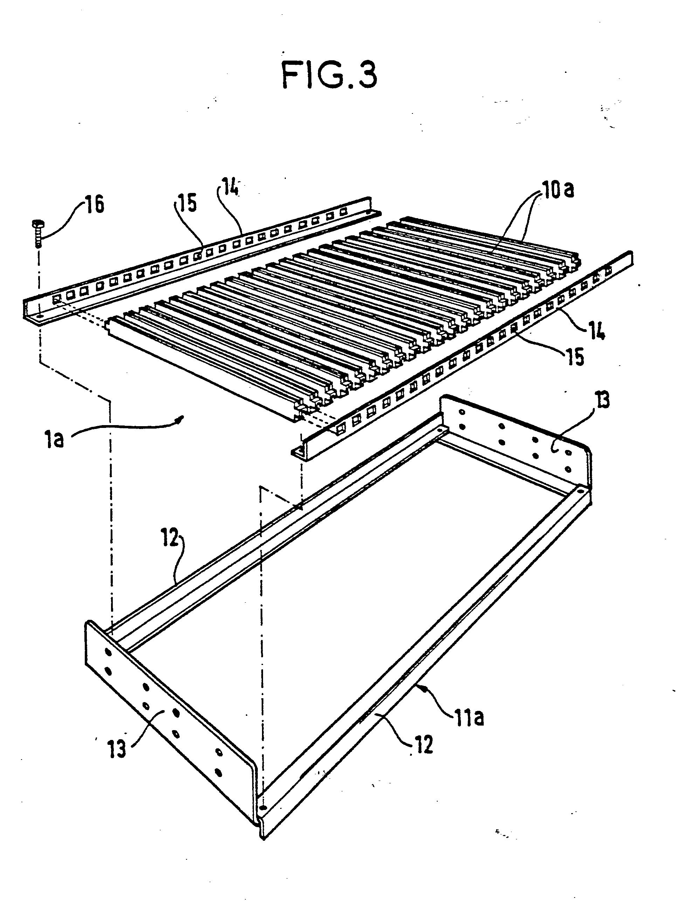

En se référent plus particulièrement à la figure 2 ou à la figure 3, chacun des plateaux précités est constitué par un cadre rectangulaire 11a ou 11b, destiné à porter l'ensemble des glissières telles que 10a et 10b et à assurer la fixation du plateau sur les montants.

Chaque cadre est obtenu par l'assemblage de deux flasques en forme de cornière tels que 12, en acier inoxydable, sur deux traverses telles que 13 également en forme de cornière et en acier inoxydable.

Les glissières 10a sont montées sur le cadre 11a par l'intermédiaire de deux cornières de maintien telles que 14 mises en opposition et présentant en vis-à-vis une même rangée de trous 15 perforés préalablement au pas entre cartes respectives à monter dans le châssis.

Les glissières 10a engagées ainsi qu'il sera plus amplement expliqué ci-après dans les trous 15 en regard des deux cornières de maintien 14 sont maintenues relativement les unes aux autres. Cet ensemble de glissières 10a alors constitué est reporté sur le cadre 11a et y est fixé au moyen de quatre vis auto-taraudeuses 16 liant les extémités des cornières aux flasques 12.

La constitution du plateau 1b formé par l'ensemble des glissières 10b maintenu sur cadre 11b est identique à celle du plateau 1a à ensemble de glissières 10a, elle n'est donc pas décrite séparément.

En se référant à la figure 2, on voit que chacun des cadres 11a et 11b est fixé sur les montants 2a et 2b au moyen de petites tiges de liaison telles que 17 ; ces tiges à têtes terminales sont ici, par paires, prisonnières dans une lame ressort 18 disposée contre la face interne de chacune des traverses 13 des cadres, sont insérées, à travers des trous formés dans les traverses et formés, à hauteur relative convenable, dans les montants et viennent s'encliqueter dans des barrettes telles que 19 disposées contre les montants. A cet effet chacune des barrettes présente deux fenêtres oblongues permettant chacune à une extrémité le passage de la tête de tige de liaison qu'elle reçoit et à l'autre le blocage de la tête de cette tige par coulissement des fenêtres donc de la barrette sur les tiges qui y sont insérées.

En se référant à nouveau à la figure 1, on comprend donc que les cadres 11a et 11b fixés sur les montants 2a et 2b et équipés de leur ensemble de glissières 10a ou 10b constituent, avec les parties des montants qui sont comprises entre les cadres, le châssis selon l'invention, ouvert sur sa face avant et sur sa face arrière. Les cartes de circuit imprimé 3, portant chacune sur une face des composants électroniques 30 et le long de leurs deux bords longitudinaux, sur l'une et l'autre des deux faces, des contacts imprimés 31 raccordés directement au circuit défini, sont alors montées dans ce châssis selon l'implantation ou l'ordre préétabli qui a déterminé le positionnement relatif des glissières de chacun des plateaux 1a et 1b. Chacune des cartes 3 est insérée dans la paire de rainures définies par deux glissières 10a et 10b en regard appartenant respectivement aux deux plateaux, ces deux glissières, telle que celle décrite ci-après, assurant le guidage de la carte dont les bords longitudinaux à contacts imprimés glissent dans cette paire de rainures, son positionnement convenable dans le châssis et enfin simultanément la connexion des contacts imprimés de la carte avec les contacts individuels du connecteur à force d'insertion nulle qui l'équipe intérieurement et le blocage de la carte.

On notera que, pour les manipulations d'insertion selon la flèche F et d'extraction de chacune des cartes, l'un des petits bords des cartes, dit bord avant pour chacune des cartes compte tenu de leur montage dans le châssis, est équipé de manière classique d'une réglette de préhension 32, ces réglettes venant après montage de l'ensemble des cartes 3 sensiblement obturer la face avant du châssis, mais pouvant aussi, si nécessaire, laisser entre elles des fentes d'aération.

En regard notamment de la figure 1, on voit que le châssis comporte, en outre, une carte de circuit imprimé supplémentaire 7b montée sur la face extérieure du plateau supérieur 1b ; ce châssis comporte, de manière analogue une autre carte supplémentaire, non visible dans cette représentation, montée sur la face extérieure du plateau inférieur 1a. Ces deux cartes supplémentaires portent notamment un circuit imprimé d'interconnexion entre les circuits définis par les cartes individuelles 3 montées dans le châssis. Ainsi que symbolisé dans cette figure 1 et qu'il sera montré plus clairement ci-après ces cartes d'interconnexion telles que 7b présentent chacune, des rangées de trous métallisés 71, en correspondance avec les glissières respectives des plateaux 1a et 1b, dont certains sont reliés par une piste imprimée telle que 72. Ces cartes d'interconnexion seront chacune montées à force sur les plateaux pour réaliser, par les pistes telles que 72, l'interconnexion des circuits définis par les cartes 3 individuelles et donc, ainsi éliminer tout autre câblage entre les circuits définis par ces cartes 3. Ces deux cartes supplémentaires, chacune de dimension nécessaire et suffisante pour supporter les interconnexions, portent également un ensemble de prises telles que 73 auxquelles sont respectivement raccordés les câbles 4 de raccordement de l'équipement électronique de ce châssis illustré à celui ou ceux d'autres châssis montés sur les montants de bâti 2a et 2b.

On notera que la construction du châssis selon l'invention, par simple montage sur les montants du bâti de deux plateaux tels que 1a et 1b, espacés l'un de l'autre de la hauteur modulaire de l'équipement électronique qu'il doit recevoir, permet de répondre de manière souple aux différents besoins. On notera aussi que la constitution de chacun des plateaux par l'assemblage relatif des glissières équipées chacune de leur connecteur à force d'insertion nulle, disposées selon l'implantation relative des différentes cartes dans l'équipement à réaliser, permet de répondre aussi de manière extrêmement souple, aux différents pas existants, dans un même équipement et d'un équipement à un autre, entre cartes de circuit imprimé. Enfin ces châssis, à face arrière ouverte, permettent une meilleure ventilation de l'équipement qui y sera contenu et par là même permettent un accroissement de densité de composants sur les différentes cartes. Enfin, ces avantages joints notamment à celui portant sur la suppression de câblage pour l'interconnexion des circuits de l'équipement conduisent à un coût de fabrication de l'appareillage résultant considérablement réduit.

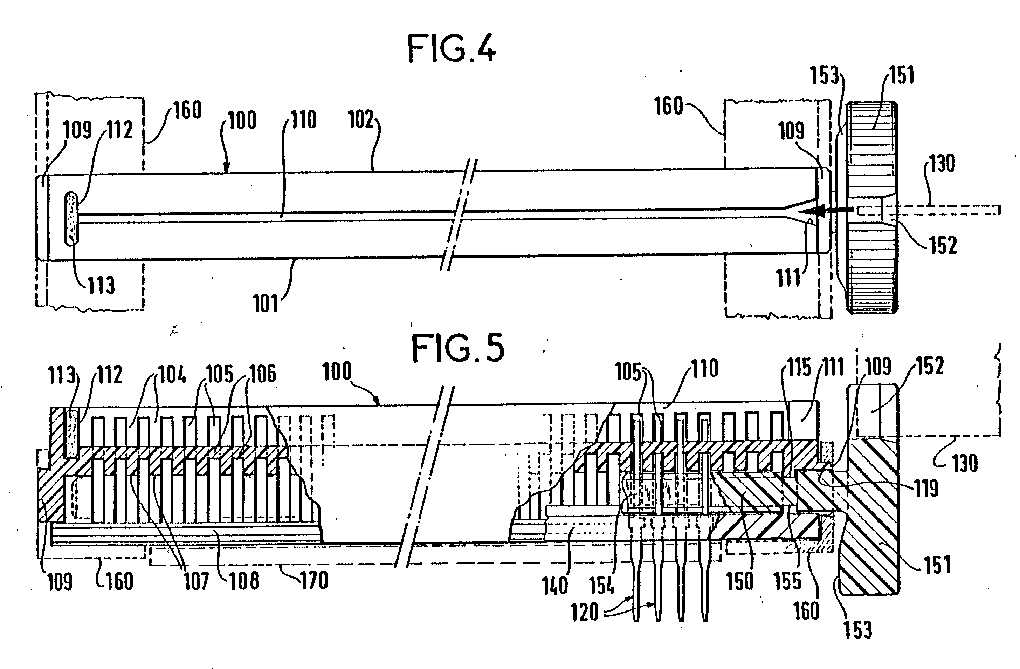

La description de ce châssis selon l'invention et d'autres avantages qu'il apporte seront complétés par la description d'un exemple de réalisation de l'une des glissières, à connecteur intérieur à force d'insertion nulle, rentrant dans la constitution des plateaux 1a et 1b. La description d'une telle glissière équipée de son connecteur est faite en regard des figures 4 à 6 et 7A, 7B, 8A et 8B.

En regard de la figure 4, on voit que la glissière équipée de son connecteur se présente extérieurement comme un corps parallélépipédique allongé.

Ainsi qu'il apparaît en regard des figures 4 à 6, 7A, 7B, 8A et 8B, la glissière équipée de son connecteur interne comporte une glissière 100, un ensemble de contacts tels que 120, une barre porte-contacts 140 et une broche rotative 150 pour la commande d'ouverture ou de fermeture de l'ensemble des contacts.

La glissière 100 s'assemble sur la barre porte-contacts 140 et constitue avec elle le corps du connecteur à partie interne partiellement évidée dans laquelle sont logés les contacts 120 et la broche rotative de commande 150.

La glissière se présente sous la forme générale d'un profilé en U renversé à base fendue, réalisé en une matière plastique et issu de moulage, qui se décompose en deux branches 101 et 102, définissant en section deux L mis en opposition mais non jointifs, les petites bases des L étant ainsi dans le même plan mais légèrement écartées l'une de l'autre en délimitant la largeur d'une rainure longitudinale 110 que présente la glissière pour le guidage et l'insertion d'une carte de circuit imprimé schématisé 130 et qui correspond à l'une des cartes 3 de la figure 1. Les deux branches 101 et 102 sont réunies par un ensemble de cloisons 104 délimitant entre elles une suite d'alvéoles 105 disposés à pas régulier sur la paroi interne de chacune des branches 101 et 102, qui servent de logements aux contacts 120.

Ces cloisons 104 présentent chacune, au droit de l'espace entre les petites bases des branches en L 101 et 102, une première découpe rectangulaire, non référencée indépendamment, pour former avec cet espace ladite rainure 110 ainsi limitée latéralement et en profondeur pour la réception d'un bord de la carte de circuit imprimé 130. Ces cloisons 104 sont également réunies entre elles, au droit de cet espace entre les petites bases des branches en L 101 et 102 dans la partie interne du connecteur par de petits ponts 106 prolongeant le fond des découpes rectangulaires dans les cloisons, pour l'obtention de la rainure 110 à fond plat et continu.

A l'opposé de la rainure 110, les cloisons présentent chacune une autre découpe 107, à fond arrondi, servant essentiellement avec les parties évidées attenantes de logement à la broche intérieure 150.

Les deux branches 101 et 102 présentent aussi chacune intérieurement, au niveau de l'extrémité du jambage vertical du L, un rainurage longitudinal 108 d'encliquetage sur la barre porte-contacts 140.

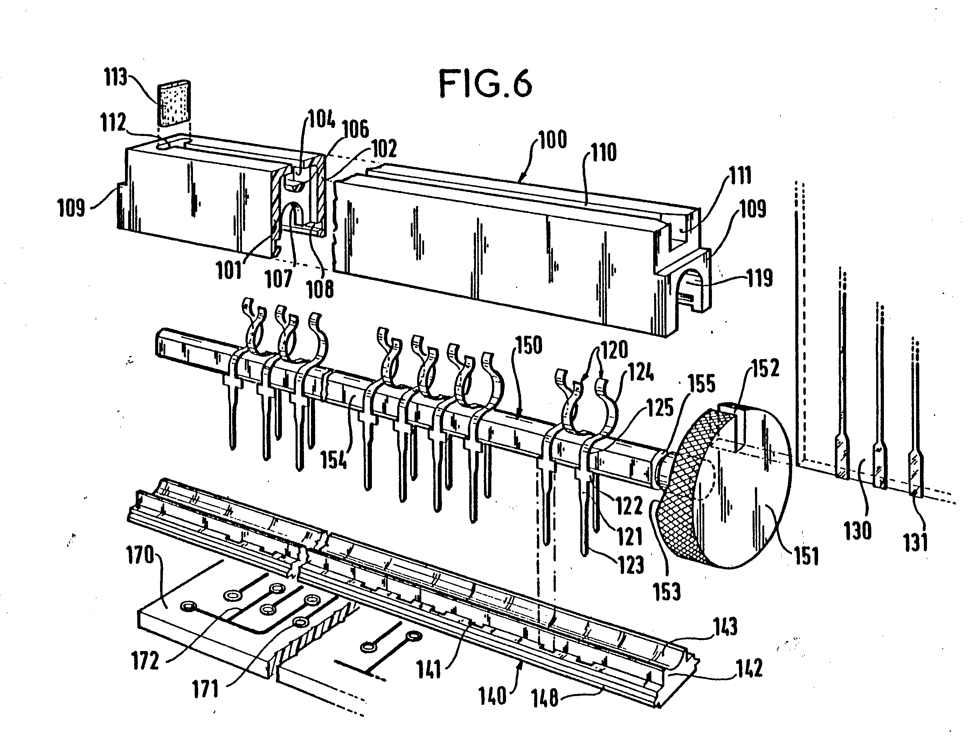

Aux deux extrémités de la glissière, les branches 101 et 102 sont réunies en définissant des parois frontales chacune équipée d'un bossage externe 109 qui permettra, ainsi que schématisé dans la figure 5 le maintien de la glissière entre deux cornières de fixation 160 perforées recevant ces bossages 109 et assurant leur fixation, conformément à la description faite ci-avant en regard de la figure 3 dans laquelle ces mêmes cornières ont été désignées par la référence 14.

Enfin, pour compléter la description de cette glissière 100, on notera que sa rainure longitudinale 110, à une extrémité formant la face avant de la glissière, est ouverte en V sur la face frontale de la glissière, ainsi que représenté dans la figure 4 en 111, tandis qu'à l'extrémité opposée elle se termine dans une boutonnière 112, simplement ouverte sur les deux petites bases des branches 101 et 102, dans laquelle est logé un tampon amortisseur 113 pour la carte 130.

On notera encore, en regard de la figure 5, que le bossage externe 109 au niveau de la face avant de la glissière, porte un passage 119 pour la broche 150 communiquant avec la découpe à fond arrondi 107 définissant le logement de cette broche 150 et que la glissière présente intérieurement un ergot semi-circulaire 115 de positionnement et de blocage longitudinal de la broche 150.

Ainsi qu'il apparaît clairement notamment en regard de la figure 6, les contacts 120 logés dans cette glissière 100 sont portés par la barre porte-contacts 140. Ces contacts se présentent chacun sous la forme générale d'une lame plate, dont une première portion terminale 121 sensiblement rectiligne présente des excroissances latérales formant deux petites pattes 122, pour son montage et sa retenue dans la barre porte-contacts et se termine sensiblement en forme de broche de contact 123, dont l'autre portion terminale opposée 124 est sensiblement en S et assure la fonction de contact du type lame-ressort avec la carte de circuit imprimé 130 et dont la portion intermédiaire 125 est elle-même arquée pour venir coopérer avec la broche 150 pour l'actionnement en ouverture ou en fermeture du connecteur.

La barre porte-contacts 140 se présente sous la forme générale d'un profilé en T renversé à jambage central court et large, réalisé comme la glissière 100 sur laquelle il est assemblé en constituant une embase, avantageusement en matière plastique, et issu de moulage. Cette barre porte-contacts 140 présente une rangée de trous 141 formés à pas régulier dans la branche horizontale du T, de chaque côté du jambage vertical central désigné par la référence 142. Les broches terminales 123 des contacts sont insérées à travers ces trous 141 et débordent de la barre porte-contacts 140, tandis que les contacts y sont fixés et maintenus par les pattes 122 précitées. Ces trous 141, appartenant à l'une des deux rangées de trous sur la barre porte-contacts 140, sont disposés en regard des intervalles entre trous de l'autre rangée, sensiblement à mi-distance entre les trous de cette autre rangée. Les deux bords d'extrémité de cette branche horizontale présentent respectivement deux rainurages longitudinaux 148 complémentaires des rainurages 108 de la glissière 100 pour leur assemblage par encliquetage mutuel de ces rainurages. Enfin le jambage vertical central 142 forme longitudinalement une gouttière semi-circulaire 143 qui sert de surface d'appui à la broche 150 et qui, lorsque la glissière 100 et la barre porte-contacts 140 sont assemblées, délimite avec le fond arrondi des découpes 107 des cloisons 104 le logement rendu alors sensiblement circulaire pour cette broche 150.

La broche 150, également en matière plastique est de longueur légèrement supérieure à celle de la glissière 100 et de la barre porte-contacts 140. Elle forme ou présente, à une extrémité qui est la face avant du connecteur une came 151 à partir de laquelle le connecteur est actionné en ouverture ou en fermeture. La came 151 comporte une fente 152, dite fente d'entrée de la carte 130, mise dans le prolongement de la rainure 110 de la glissière 100 par une rotation convenable de la came. Cette came 151 est également d'épaisseur non uniforme pour définir un profilé arrière 153 tel qu'illustré dans les figures 4 et 5 notamment facilitant la rotation de la came après mise en place de la carte 130 dans la rainure 110 et provoquant ensuite le blocage longitudinal de la carte dans la rainure.

La broche 150 commandée en rotation par la came 151 est de forme générale cylindrique et présente, sur au moins la longueur de sa partie intérieure à la glissière et l'embase assemblées, deux méplats opposés 154. Elle présente enfin, au voisinage de la came 151, une gorge périphérique 155 assurant, ainsi que visible dans la figure 5, avec l'ergot semi-circulaire 115 de la glissière 100, le blocage en positionnement longitudinal de la broche 150 dans le corps du connecteur.

Lors de l'assemblage de la glissière 100 et de la barre porte-contacts 140 sur laquelle sont montés les contacts 120, cette broche 150 reçoit sur sa périphérie, au niveau des méplats 154, les portions intermédiaires arquées 125 des contacts 120, qui la contournent partiellement, ces portions intermédiaires 125 s'appliquant sans pression contre les méplats alors parallèles aux jambages verticaux des deux branches en L 101 et 102 de la glissière. On comprendra donc, en regard de la figure 6 et de la figure 5 notamment, que la broche 150 peut recevoir alternativement d'un côté et de l'autre de son plan médian passant par l'axe de la rainure 110 les portions intermédiaires des contacts montés dans les trous 141 successifs des deux rangées de trous de la barre porte-contacts et que les portions terminales 124 en S de ces mêmes contacts seront disposées inversement par rapport à ce plan médian et définiront deux rangées de contacts avec la carte 130. Au voisinage de la barre porte-contacts 140, les contacts 120 logés dans les alvéoles définis par les cloisons 104 sur l'une des branches 101 ou 102 de la glissière viendront, en s'appliquant contre la broche 150 et en la contournant sensiblement sur un quart de sa périphérie, se loger dans les alvéoles définis par les mêmes cloisons sur l'autre branche 102 ou 101 de la glissière du côté de la rainure 110.

En regard de l'organisation des contacts 120 d'un côté et de l'autre de la broche 150 et selon deux rangées d'un côté et de l'autre du plan médian de la rainure 110, on notera que ces contacts viendront coopérer avec des pistes conductrices, telles que 131, déposées ou imprimées sur l'une et l'autre des deux faces de la carte au voisinage de son bord inséré dans la rainure 110, ces pistes 131 étant décalées d'une face à l'autre et à des emplacements auxquels correspondent ceux des contacts 120 le long du connecteur. On notera également que, selon les connexions à assurer avec la carte 130, celle-ci ne sera équipée que du nombre de contacts 131 nécessaires et que le connecteur ne comportera alors que le même nombre de contacts 120 disposés le long du connecteur et selon l'une ou l'autre des deux rangées de contacts en correspondance avec la disposition des pistes 131 sur la carte 130.

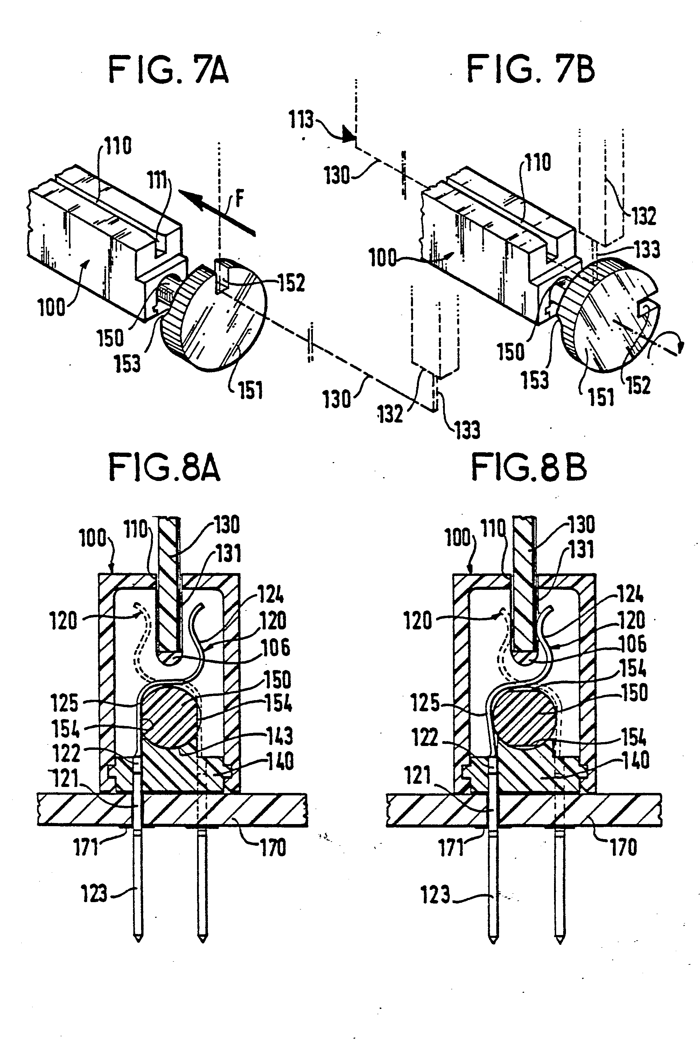

Enfin, dans les figures 7A et 7B on a schématisé respectivement les commandes du connecteur, en position d'ouverture pour l'insertion de la carte 130 et en position de fermeture pour laquelle la carte est bloquée dans le connecteur, ces deux positions d'ouverture et de fermeture étant données respectivement dans les deux coupes des figures 8A et 8B.

Dans les figures 7A et 8A par l'actionnement en rotation de la came 151 amenant la fente 152 dans le prolongement de la rainure 110, la carte 130 peut être introduite selon la flèche F depuis la fente 152 dans la rainure. Dans cette position, la fente 152 étant dans le prolongement de la rainure, la portion arquée des contacts s'appuie pratiquement sans pression contre les méplats 154 et relâche les portions terminales en S 124 qui s'écartent du plan médian de la rainure et du bord de la carte 130 : les contacts sont alors en position ouverte.

Dans les figures 7B et 8B, par l'actionnement en rotation de la came 151, amenant la fente 152 perpendiculairement à la rainure 110, cet actionnement n'étant possible que lors de l'insertion totale de la carte 130 dans la rainure 110, la carte 130 est bloquée entre le tampon amortisseur schématisé en 113 et la surépaisseur du profilé arrière 153 de la came. Les portions intermédiaires arquées des contacts 120 s'appliquent avec pression contre l'une ou l'autre des parties semi-cylindriques de la broche 150 qui les repoussant provoque le resserrement des portions terminales en S vers le plan médian de la rainure 110 donc contre la carte 130. Pour un meilleur actionnement de la came 151, lors du verrouillage de la carte 130 dans la rainure 110, l'extrémité avant du bord de la carte logé dans la rainure se terminera avantageusement en biseau et viendra alors coopérer avec le profilé arrière de la came, ce biseau non illustré étant formé sur l'extrémité 133 de la face avant de la carte, non recouverte d'une réglette de préhension 132 (figures 7A et 7B).

Ainsi qu'il ressort de la figure 6 et qu'il apparaît dans les figures 5, 8A et 8B, les portions terminales 121 des contacts 120 qui forment des broches de contacts, traversent la barre porte-contacts 140 et débordent sur la face externe de la barre porte-contacts assemblée sur la glissière 100. Elles permettent le raccordement du circuit porté par la carte 130 à un ou plusieurs autres circuits portés par des cartes analogues par l'intermédiaire d'un circuit d'intercâblage imprimé sur une carte supplémentaire 170 dont les trous métallisés 171 permettent de la raccorder à force, sans soudure, sur les broches du connecteur en assurant, par les pistes 172 (figure 6) du circuit d'intercâblage les connexions convenables (cette carte d'interconnexion ayant été représentée dans la figure 1 sous la référence 7b, avec ses trous métallisés et ses pistes imprimées désignées respectivement par les références $7_1$ et $7_2$).

En regard des figures 8A et 8B, on notera encore qu'outre le guidage longitudinal de la carte 130 lors de son insertion et son blocage ou verrouillage lors de son positionnement final, la disposition des contacts 120 dans la glissière 100 associée à leur commande ne permettent l'entrée de la carte 130 que lorsque le connecteur est ouvert c'est-à-dire lorsque les contacts 120 sont tous en retrait par rapport à la rainure 110 et donc bien protégés contre tout endommagement dans la glissière.

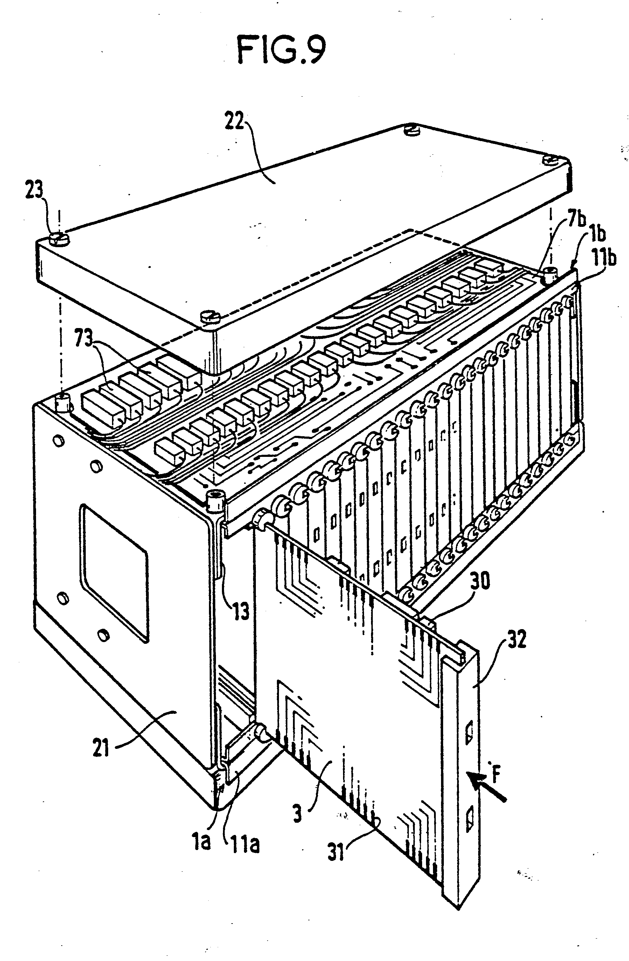

En regard de la figure 9, on a illustré le montage en coffret d'un équipement électronique. La mise en coffret d'un équipement défini par les circuits portés par une pluralité de cartes de circuit imprimé analogues aux cartes 3 de la figure 1 et de ce fait désignées par cette même référence est effectuée d'une manière tout à fait analogue à la mise en bâti d'un équipement analogue illustré dans la figure 1 et seules les particularités de cette réalisation seront indiquées, les éléments analogues étant simplement mentionnés et/ou désignés par les références les désignant dans la figure 1. Ce montage en coffret de l'équipement électronique diffère essentiellement du montage en bâti par le fait que le châssis recevant les cartes de circuit imprimé 3 est constitué par les deux plateaux à ensemble de glissières équipées de leur connecteur, tels que les plateaux 1a et 1b précédents, qui sont directement montés sur deux parois latérales telles que 21 appartenant au coffret et, par rapport à la figure 1 se substituant aux parties des montants situées entre les plateaux, la constitution des plateaux et leur montage sur ces parois 21 restant analogues à ceux illustrés dans les figures 1 à 3. Un couvercle 22, un fond analogue au couvercle et une paroi arrière analogue aux parois latérales 21 non visibles ici, sont alors simplement rapportées sur les cartes d'interconnexion telles que 7b recouvrant les faces externes des plateaux et sur la face arrière ouverte du châssis, au moyen de vis telles que 23 les fixant sur les cadres tels que 11b des plateaux.

REVENDICATIONS

1/ Châssis d'équipement électronique, destiné à recevoir des cartes de circuit imprimé portant des composants et à assurer au moins les connexions entre circuits définis par les cartes individuelles, caractérisé par le fait qu'il comporte deux plateaux (1a, 1b) fixés sur des montants (2a, 2b ; 21) , à une distance l'un de l'autre sensiblement égale à la hauteur desdites cartes (3), chacun constitué par un ensemble de glissières (10a, 10b) maintenues sur un cadre (11a, 11b), au pas de montage des cartes respectives dans le châssis, et ayant des rainures (110) de guidage desdites cartes disposées d'un plateau à l'autre en vis-à-vis, et intérieurement chacune un connecteur de circuit imprimé à contacts (120) mobiles transversalement à la rainure (110) de la glissière correspondante, à proximité de cette rainure.

2/ Châssis selon la revendication 1, caractérisé par le fait que chacun desdits plateaux (1a, 1b) comporte deux cornières de maintien (14) mises en opposition et présentant une même rangée de trous (15) perforés au pas de montage desdites cartes respectives dans le châssis, assurant le positionnement relatif des glissières (10a, 10b) engagées dans les trous en regard des cornières et la fixation de cet ensemble de glissières sur ledit cadre.

3/ Châssis selon la revendication 2, caractérisé par le fait que chacune desdites glissière équipée de son connecteur intérieur et d'une broche rotative intérieure (150) d'actionnement en ouverture ou fermeture de ses contacts est constituée par :

- la glissière proprement dite (100) de profilé en U, fendue longitudinalement en définissant deux branches en L (101, 102) montées en opposition et non jointives limitant transversalement ladite rainure

- et une barre porte-contacts (140) de profilé en T renversé obturant le profilé en U, définissant une gouttière (143) longitudinale semi-cylindrique intérieure à la glissière d'appui de ladite broche (150) et assurant le maintien desdits contacts (120) dont les portions terminales (124), à l'opposé de cette barre porte-contacts s'étendent en au moins une rangée au voisinage de ladite rainure.

4/ Châssis selon la revendication 3, caractérisé par le fait que lesdits plateaux (1a, 1b) présentent sur la longueur de chaque glissière (10a, 10b) équipée de son connecteur au moins une rangée de broches de contacts (123) extérieures à ladite glissière, à l'opposé de ladite rainure, constituées par les portions terminales (121) correspondantes desdits contacts (120) et qu'il comporte, en outre, une carte d'interconnexion (7b, 170), à rangées de trous métallisés (171) correspondant aux rangées de broches de contacts de chacun desdits plateaux (1a, 1b) et à circuit d'intercâblage (172) formé entre une partie de ces trous (171), insérée à force sur au moins l'un desdits plateaux (1a, 1b) en recouvrant sa face externe dans le châssis.

5/ Châssis selon l'une des revendications 3 et 4, caractérisé en ce que ladite broche (150) présente une came d'extrémité (151) extérieure à ladite glissière (10a, 10b) équipée de son connecteur, ayant une fente (152), pouvant être positionnée, par rotation de la came, dans le prolongement de ladite rainure (110) et ayant un profilé arrière (153) présentant une surépaisseur pour le blocage longitudinal de ladite carte de circuit imprimé (3, 130) dans ladite rainure.

0068195

# FIG.1

0068195

# FIG.2

# FIG.3

FIG.4

FIG.5

FIG.6

0068195

0068195

# FIG. 7A

# FIG. 7B

# FIG. 8A

# FIG. 8B

0068195

# FIG.9

## DOCUMENTS CONSIDERES COMME PERTINENTS

| Categorie | Citation du document avec indication, en cas de besoin, des parties pertinentes | Revendication concernee | CLASSEMENT DE LA DEMANDE (Int. Cl. 3) |
|---|---|---|---|
| Y | US-A-4 158 220 (FUJITSU CORP.) * colonne 2, ligne 31 - colonne 3, ligne 54; figures 1,2 * | 1 | H 05 K 7/14 H 01 R 23/68 |
| Y | US-A-3 699 393 (G.T.E. AUTOMATIC ELECTRIC LABORATORIES) * colonne 2, lignes 16-41; figure 1 * | 1 | |
| A | DE-A-2 714 563 (BROWN BOVERI & CIE.) | | |
| A | US-A-3 549 950 (NATIONAL METAL KRAFTERS INC.) | | |
| A | FR-A-2 185 914 (SOURIAU & CO.) | | |

| DOMAINES TECHNIQUES RECHERCHES (Int. Cl. 3) |
|---|
| H 05 K H 01 R |

Le present rapport de recherche a ete etabli pour toutes les revendications

| Lieu de la recherche | Date d achevement de la recherche | Examinateur |
|---|---|---|
| LA HAYE | 22-09-1982 | SCHUERMANS N.F.C. |

CATEGORIE DES DOCUMENTS CITES

X particulierement pertinent a lui seul
Y particulierement pertinent en combinaison avec un autre document de la meme categorie
A arriere-plan technologique
O divulgation non-ecrite
P document intercalaire

T : theorie ou principe a la base de l'invention
E : document de brevet anterieur, mais publie à la date de depôt ou apres cette date
D : cite dans la demande
L : cite pour d autres raisons

& membre de la meme famille document correspondant